# EUROPEAN PATENT APPLICATION

(11) **EP 4 368 743 A1**
(43) Date of publication of application: **15.05.2024**
(21) Application number: 22837582.0
(22) Date of filing: 30.06.2022
(51) Int. Cl.: C23C 16/02, C23C 16/27, C30B 29/04

(54) **DIAMOND FILM FORMATION METHOD, DIAMOND FILM FORMATION DEVICE, PROGRAM, AND DIAMOND MATERIAL**

(30) Priority: 09.07.2021 JP 2021113975
(71) Applicant: Disco Corporation, Tokyo 143-8580 (JP); National University Corporation Nagaoka University of Technology, Nagaoka-shi Niigata 940-2188 (JP); Sawabe Atsuhito, Sagamihara-shi, Kanagawa 252-5258 (JP); Kimura, Yutaka, Sagamihara-shi, Kanagawa 252-5258 (JP)
(72) Inventor: AIDA, Hideo, Nagaoka-shi, Niigata 940-2188 (JP); OSHIMA, Ryuji, Tokyo 143-8580 (JP); SAWABE, Atsuhito, Sagamihara-shi, Kanagawa 252-5258 (JP); KIMURA, Yutaka, Sagamihara-shi, Kanagawa 252-5258 (JP)
(74) Representative: V.O.
(86) International application number: PCT/JP2022/026180
(87) International publication number: WO 2023/282166

(57) **Abstract**

The diamond deposition method includes: a base layer formation step of forming a base layer (22) by a CVD method using a first raw material gas containing iridium; and a diamond layer formation step of forming a single-crystal diamond layer (23) on the base layer (22) by the CVD method using a second raw material gas containing a hydrocarbon gas.

## Description

### Technical Field

The present disclosure relates to a diamond deposition method, a diamond deposition device, a program, and a diamond material.

### Background Art

A method for producing an epitaxial diamond film described in Patent Literature 1, for example, includes an iridium thin film production step, a bias nucleation step, and an epitaxial diamond growth step.

The above iridium thin film production step is a step to deposit an iridium thin film on a substrate by epitaxial growth using a high-frequency sputtering method. In this iridium thin film production step, not only the high-frequency sputtering method but also a direct current (DC) sputtering method is known to be used.
The above bias nucleation step is a step to form epitaxial diamond nuclei by exposing the deposited iridium base surface to plasma containing ions using a confront electrode type DC plasma generator.

The above epitaxial diamond growth step is a step to grow epitaxial diamond on the bias nucleation-treated surface of the epitaxial diamond film base substrate using a multi-electrode DC plasma chemical vapor deposition (CVD) device by a CVD method.

### Citation List

### Patent Literature

Patent Literature 1: Unexamined Japanese Patent Application Publication No. 2007-270272

### Summary of Invention

### Technical Problem

In the configuration of the above Patent Literature 1, a high-frequency sputtering device is used in the iridium thin film production step, a confront electrode type DC plasma generator is used in the bias nucleation step, and a multi-electrode DC plasma CVD device is used in the epitaxial diamond growth step. Thus, the production of a diamond film is not easy, requiring multiple types of devices or methods.

The present disclosure was made in view of the above circumstances and the objective of the present disclosure is to provide a diamond deposition method, a diamond deposition device, a program, and a diamond material that facilitates easier formation of a diamond layer.

### Solution to Problem

To achieve the above objective, a diamond deposition method according to a first aspect of the present disclosure includes: a base layer formation step of forming a base layer by a CVD method using a first raw material gas containing at least one metal selected from a group consisting of iridium, platinum, rhodium, titanium, and tungsten; and a diamond layer formation step of forming a single-crystal diamond layer on the base layer by the CVD method using a second raw material gas containing a hydrocarbon gas.

To achieve the above objective, a diamond deposition device according to a second aspect of the present disclosure includes: a chamber; a first raw material gas supplier to supply a first raw material gas containing at least one metal selected from a group consisting of iridium, platinum, rhodium, titanium, and tungsten into the chamber; a second raw material gas supplier to supply a second raw material gas containing a hydrocarbon gas into the chamber; and an energy supplier to provide energy to the first raw material gas that is supplied into the chamber by the first raw material gas supplier so as to form a base layer or an intercalation layer inside the camber and to provide energy to the second raw material gas that is supplied into the chamber by the second raw material gas supplier so as to form a diamond layer on the base layer or the intercalation layer.

To achieve the above objective, a program according to a third aspect of the present disclosure causes a computer to perform: a base layer formation procedure of forming a base layer by a CVD method using a first raw material gas containing at least one metal selected from a group consisting of iridium, platinum, rhodium, titanium, and tungsten; and a diamond layer formation procedure of forming a single-crystal diamond layer on the base layer by the CVD method using a second raw material gas containing a hydrocarbon gas.

To achieve the above objective, a diamond material according to a fourth aspect of the present disclosure includes: a base layer containing at least one metal selected from a group consisting of iridium, platinum, rhodium, titanium, and tungsten; a first diamond layer formed on the base layer; an intercalation layer formed on the first diamond layer and configured to contain the same metal as the base layer; and a second diamond layer formed on the intercalation layer, the second diamond layer being different from the first diamond layer.

### Advantageous Effects of Invention

According to the present disclosure, a diamond layer can be formed more easily.

### Brief Description of Drawings

FIG. 1 is a schematic diagram of a diamond deposition device according to an embodiment of the present disclosure;
FIG. 2A is a schematic diagram of a substrate supporter and a substrate before generating a diamond material according to an embodiment of the present disclosure;
FIG. 2B is a schematic diagram of a base layer after a base layer formation step according to the embodiment of the present disclosure;
FIG. 2C is a schematic diagram of the base layer and a diamond layer after a diamond layer formation step according to the embodiment of the present disclosure;
FIG. 3A is a schematic diagram of a base layer, a diamond layer, and an intercalation layer after an intercalation layer formation step according to a variation of the present disclosure; and
FIG. 3B is a schematic diagram of the base layer, two diamond layers, and intercalation layer after a second diamond layer formation step according to the variation of the present disclosure.

### Description of Embodiments

An embodiment of the diamond deposition method, diamond deposition device, program, and diamond material according to the present disclosure is described below with reference to the drawings. The diamond deposition device of the present embodiment is, for example, a microwave plasma CVD device.

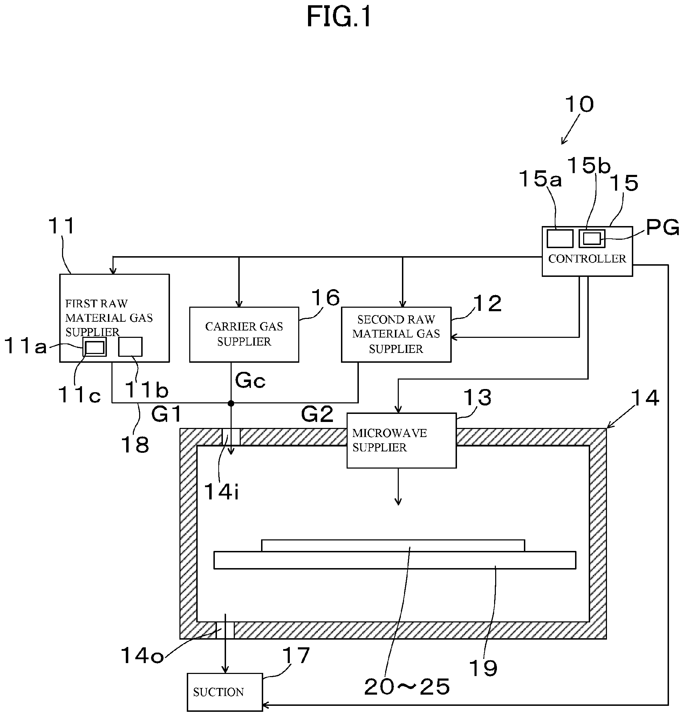

As illustrated in FIG. 1, the diamond deposition device 10 includes: a first raw material gas supplier 11, a second raw material gas supplier 12, a carrier gas supplier 16, a microwave supplier 13, a chamber 14, a controller 15, a suction 17, a substrate supporter 19, and a gas tube 18.

The chamber 14 is provided with the substrate supporter 19 that supports a substrate 21. The microwave supplier 13 generates microwaves as energy to promote chemical reactions of a gas and supplies the generated microwaves into chamber 14.

The chamber 14 has a gas suction hole 14i and a gas discharge hole 14o. The suction 17 is connected to the gas discharge hole 14o via a gas tube, not illustrated, and suctions a mixed gas in the chamber 14 under control of the controller 15.

The first raw material gas supplier 11 is connected to the gas suction hole 14i via the gas tube 18. Under control of the controller 15, the first raw material gas supplier 11 can supply the first raw material gas G1 into the chamber 14 and control the flow rate of the supplied first raw material gas G1. The first raw material gas G1 is a gas made from an organometallic compound of which metal is iridium (Ir). This iridium (Ir) is, for example, tris(acetylacetonato)iridium(III) (C15H21Ir06).

The first raw material gas supplier 11 includes a housing 11a and a gas generator 11b.

The housing 1 1a houses alcohol 11c in which tris(acetylacetonato)iridium is dissolved. The gas generator 11b heats the alcohol 11c in the housing 11a to evaporate the alcohol 11c and generate the first raw material gas G1. For example, this alcohol 11c evaporates at less than 100 °C, such as 30 °C.

The second raw material gas supplier 12 is connected to the gas suction hole 14i via the gas tube 18. Under control of the controller 15, the second raw material gas supplier 12 can supply the second raw material gas G2 into the chamber 14 and control the flow rate of the supplied second raw material gas G2. The second raw material gas G2 includes, for example, a hydrocarbon gas that serves as a carbon source, such as methane (CH4) or acetylene (C2H2), diluted with a noble gas such as hydrogen (H2), argon (Ar), nitrogen (N2), or helium (He).

The carrier gas supplier 16 is connected to the gas suction hole 14i via the gas tube 18 and supplies the carrier gas Gc into the chamber 14 under control of the controller 15. The carrier gas Gc consists of a noble gas such as hydrogen (H2), argon (Ar), nitrogen (N2), or helium (He) and is used to carry the first raw material gas G1 or the second raw material gas G2.

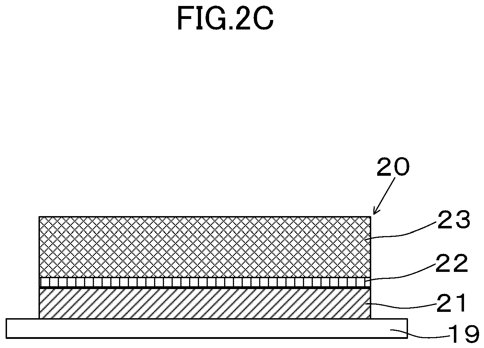

The controller 15 controls the first raw material gas supplier 11, the second raw material gas supplier 12, the microwave supplier 13, and the suction 17. The controller 15 includes a processor 15a, consisting of a central processing unit (CPU) or the like, and a memory 15b, consisting of a read only memory (ROM), a random access memory (RAM), or the like. The memory 15b stores in advance a program PG in which a processing procedure of the processor 15a is specified. The processor 15a generates the diamond material 20 (refer to FIG. 2C) described below according to the program PG.

Next, the procedure for generating the diamond material 20 is described. The diamond deposition device 10 performs the base layer formation step (Step 1) and the diamond layer formation step (Step 2) in sequence to generate the diamond material 20 according to the program PG.

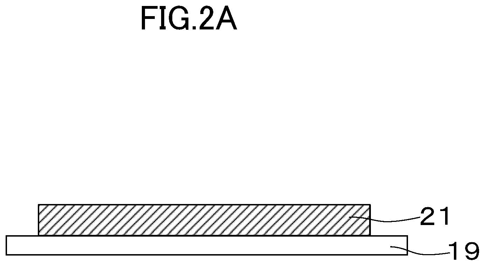

First, in performing the base layer formation step, the substrate 21 is installed on the substrate supporter 19 inside the chamber 14, as illustrated in FIG. 2A. The substrate 21 is, for example, single-crystal magnesium oxide (MgO), single-crystal sapphire (A1203), or silicon (Si). The substrate supporter 19 incorporates a heater, not illustrated in the drawings, by which the temperature of the substrate 21 is controlled, under the control of the control unit 15, to a temperature suitable for growing the base layer 22 and the diamond layer 23 as described below.

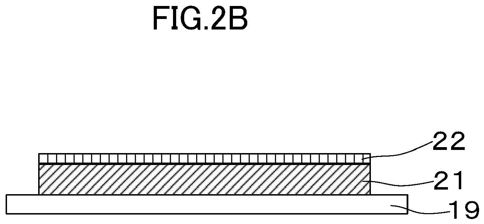

In the base layer formation step, the controller 15 supplies the first raw material gas G1 to the gas tube 18 via the first raw material gas supplier 11 and supplies the carrier gas Gc to the gas tube 18 via the carrier gas supplier 16. As a result, a mixed gas in which the first raw material gas G1 and the carrier gas Gc are mixed is supplied into the chamber 14. At this time, the supply of the second raw material gas G2 from the second raw material gas supplier 12 is stopped. The controller 15 supplies microwaves to the mixed gas including the first raw material gas G1 in the chamber 14 via the microwave supplier 13. This activates the first raw material gas G1 in the chamber 14 to become a plasma state, and, as illustrated in FIG. 2B, a base layer 22 is formed on the substrate 21 from the first raw material gas G1 in which an organometallic compound is gasified. The base layer 22 includes, for example, a metal mixed with carbon, in this example, iridium. The carbon mixed in the base layer 22 serves as diamond nuclei.

This completes the base layer formation step.

Next, in the diamond layer formation step, the controller 15 supplies the second raw material gas G2 to the gas tube 18 via the second raw material gas supplier 12 and supplies the carrier gas Gc to the gas tube 18 via the carrier gas supplier 16. As a result, a mixed gas in which the second raw material gas G2 and the carrier gas Gc are mixed is supplied into the chamber 14. At this time, the supply of the first raw material gas G1 from the first raw material gas supplier 11 is stopped. The microwave supplier 13 supplies microwaves to the mixed gas containing the second raw material gas G2 in the chamber 14. This activates the second raw material gas G2 in the chamber 14 to become a plasma state, and, as illustrated in FIG. 2C, a single-crystal diamond layer 23 is formed on the base layer 22 from the second raw material gas G2 in which hydrocarbons are gasified with the carbon contained in the base layer 22 as nuclei.

This completes the diamond layer formation step. As a result, a diamond material 20 having a base layer 22 and a diamond layer 23 is produced by a diamond deposition device 10 as a single device using a CVD method as a single method.

According to the embodiment described above, the following effects are achieved.
(1) The diamond deposition method includes a base layer formation step of forming a base layer 22 is on a substrate 21 by a CVD method using a first raw material gas G1 containing iridium as metal and a diamond layer formation step of forming a single-crystal diamond layer 23 on the base layer 22 by the CVD method using a second raw material gas G2 containing a hydrocarbon gas.

According to this configuration, both the base layer 22 and the diamond layer 23 can be formed by the CVD method. Therefore, multiple types of devices are not required as in the configuration of Patent Literature 1, and a single type of CVD device, namely, the diamond deposition device 10, can easily form the base layer 22 and the diamond layer 23 on the substrate 21.

(2) In the base layer formation step, the carbon-mixed base layer 22 is formed on the substrate 21 by the CVD method using the first raw material gas G1 containing an organic iridium compound in which iridium and carbon are bonded. In the diamond layer formation step, the diamond layer 23 is formed using the carbon that is mixed in the base layer 22 as nuclei.

According to this configuration, the diamond layer 23 can be formed easily and quickly, without the need to perform processing to form carbon in the base layer 22, such as bias enhanced nucleation (BEN) treatment.

(3) The diamond material 20 has a base layer 22 and a diamond layer 23 each formed by the CVD method.

According to this configuration, it is easy to form the diamond material 20.

(4) The diamond deposition device 10 includes: a chamber 14; a first raw material gas supplier 11 for supplying a first raw material gas G1 containing iridium into the chamber 14; a second raw material gas supplier 12 for supplying a second raw material gas G2 containing a hydrocarbon gas into the chamber 14; and a microwave supplier 13 as an example of an energy supplier for energizing the first raw material gas G1 supplied into the chamber 14 by the first raw material gas supplier 11 so as to form a base layer 22 on the substrate 21 installed inside the chamber 14 and energizing the second raw material gas G2 supplied into the chamber 14 by the second raw material gas supplier 12 so as to form a diamond layer 23 on the base layer 22.

According to this configuration, the base layer 22 and the diamond layer 23 can be easily formed on the substrate 21, as described above.

To realize the functions of the three types of devices described in the above Patent Literature 1 in a single chamber, the temperature in the chamber is required to be raised or lowered for each step, which is time-consuming and labor-intensive. In this respect, according to the above configuration, since only one type of CVD device is required, the adjustment range of temperature control in the chamber 14 can be reduced, and the base layer 22 and the diamond layer 23 can be formed more easily.

(5) The first raw material gas supplier 11 includes: a housing 11a that houses alcohol 11c that is an example of a solvent in which an organic iridium compound, a type of organometallic compound in which iridium and carbon are bonded, is dissolved; and a gas generator 1 1b that generates the first raw material gas G1 by evaporating the alcohol 11c housed in the housing 11a.

If the organometallic compound is solid, this solid must be heated at a high temperature to generate the first raw material gas G1. In this respect, according to the above configuration, since the organic iridium compound is dissolved in the alcohol 11c, the first raw material gas G1 can be made by evaporating the alcohol 11C at a low temperature. Therefore, since a heater with a low heating temperature can be employed as the gas generator 1 1b, the configuration of the diamond deposition device 10 can be simplified.

(6) The controller 15, an example of a computer, is caused to perform a base layer formation procedure to form a base layer 22 on a substrate 21 by a CVD method using a first raw material gas G1 containing iridium as metal and a diamond layer formation procedure to form a single-crystal diamond layer 23 on the base layer 22 by the CVD method using a second raw material gas G2 containing a hydrocarbon gas.

According to this configuration, the base layer 22 and diamond layer 23 can be easily formed.

Note that the present disclosure is not limited by the above embodiment and drawings. Modifications (including deletion of components) can be made as appropriate to the extent that the gist of the present disclosure is not changed. An example of variations is described below.

### (Variation)

In the above embodiment, the diamond deposition device 10 is a microwave plasma CVD, but the diamond deposition device 10 may be a different plasma CVD, such as a direct current (DC) plasma CVD, a radio frequency (RF) plasma CVD, or a high density plasma CVD. Furthermore, the diamond deposition device 10 is not limited to a plasma CVD, but may be a different CVD device, such as a thermal CVD or an optical CVD.

The diamond deposition device 10 may perform an intercalation layer formation step (Step 3) and a second diamond layer formation step (Step 4) after the base layer formation step (Step 1) and the first diamond layer formation step (Step 2) in the above embodiment.

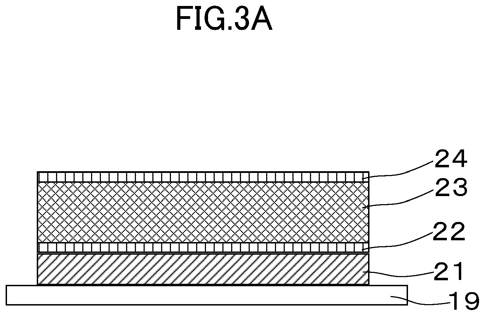

For example, the diamond deposition device 10 forms an intercalation layer 24 on the diamond layer 23 in the intercalation layer formation step, as illustrated in FIG. 3A, by the CVD method using the first raw material gas G1, similar to the base layer formation step described above. The intercalation layer 24, like the base layer 22, contains, for example, iridium mixed with carbon. The intercalation layer formation step corresponds to a second base layer formation step, and the intercalation layer 24 corresponds to a second base layer.

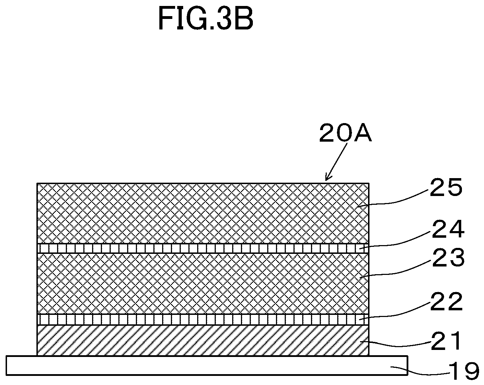

After the intercalation layer formation step, the diamond deposition device 10 performs the second diamond layer formation step (Step 4) by the CVD method using the second raw material gas G2 as in Step 2. As illustrated in FIG. 3B, a diamond layer 25 is thus formed on the intercalation layer 24. The above steps generate a diamond material 20A. The diamond material 20A has the base layer 22, the diamond layer 23 that is an example of the first diamond layer, the intercalation layer 24, and the diamond layer 25 that is an example of the second diamond layer.

Note that, although the diamond material 20A illustrated in FIG. 3B has two diamond layers 23, 25, without limitation, the diamond material 20A may have three or more diamond layers, with an intercalation layer formed between each two of the diamond layers.

According to the variation described above, the following effects are achieved.

The diamond deposition method includes: an intercalation layer formation step of forming an intercalation layer 24 containing a metal on a diamond layer 23, an example of the first diamond layer, by a CVD method using a first raw material gas G1 containing an organic iridium compound in which iridium is selected as metal; and a second diamond layer formation step, different from the first diamond layer formation step that is the initial diamond layer formation step, of forming a diamond layer 25, an example of the second diamond layer different from the diamond layer 23, on the intercalation layer 24 by the CVD method using a second raw material gas G2 containing a hydrocarbon gas.

If one diamond layer is formed thicker, the strain of the diamond layer may increase. Therefore, by sandwiching an intercalation layer 24 between the diamond layers 23, 25 as in the above configuration, the strain of the diamond layers 23, 25 can be expected to be reduced. The intercalation layer 24 is also expected to compensate for crystal defects in the diamond layers 23, 25. Furthermore, the diamond material 20A can be easily formed with a single type of CVD device, that is, the diamond deposition device 10.

In the above embodiment or variation, the first raw material gas G1 is a gas made from an organic iridium compound whose metal is iridium, but the first raw material gas G1 may be a gas made from an organometallic compound whose metal is platinum, rhodium, titanium or tungsten other than iridium. In this case, the base layer 22 or the intercalation layer 24 contains carbon and any of the metals of platinum, rhodium, titanium, or tungsten.

In the above embodiment or variation, the supply of the first raw material gas G1 from the first raw material gas supplier 11 is stopped in the diamond layer formation step. However, without limitation, the first raw material gas G1 may be supplied. For example, in at least any of the second and fourth steps of the diamond layer formation step, a mixed gas in which the first raw material gas G1, the second raw material gas G2, and the carrier gas Gc are mixed is supplied into the chamber 14. The mixed gas containing the first raw material gas G1 and the second raw material gas G2 is made into a plasma state, thereby forming diamond layers 23, 25 containing the metal component from the first raw material gas G1. The metal component contained in the diamond layers 23, 25 are the same as those contained in the base layer 22 or the intercalation layer 24.

Note that the diamond layers 23, 25 containing the metal component may be stacked without the intercalation layer 24. In this case, the diamond layers 23, 25 may be formed so that each diamond layer 23, 25 contains a different amount of the metal component.

According to the variation described above, the following effects are achieved.

In the diamond layer formation step, the second raw material gas G2 is mixed with the first raw material gas G1 to mix the metal into the diamond layers 23, 25. As a result, the diamond layers 23, 25 are diffused with the same metal component as the base layer 22.

According to this configuration, by mixing the metal, the properties of the diamond layers 23, 25, such as electrical or mechanical properties, can be changed to suit the intended use. For example, defects such as dislocations in the diamond layers 23, 25 can be expected to be suppressed.

By adopting a configuration in which the gas generator 11b evaporates the alcohol 11c in the housing 11a in which a metal is dissolved, the metal component is expected to be uniformly distributed in the diamond layers 23, 25. This allows, for example, the diamond layers 23, 25 to be in a state where the metal component is diffused at the atomic or molecular level. The degree of distribution or diffusion of the metal component in the diamond layers 23, 25 can be adjusted by adjusting the flow rate of the first raw material gas G1.

The concentration of the first raw material gas G1 relative to the second raw material gas G2 may be different between the diamond layers 23, 25. This allows the ratio of the volume of the metal component to the volume of the entire diamond layers 23, 25 to be adjusted. Alternatively, only one of the two diamond layers 23, 25 may be mixed with the metal and the other layer may not be mixed with the metal.

In the above embodiment, the diamond deposition device 10 forms a base layer 22 containing a metal mixed with carbon in the base layer formation step. However, without limitation, the diamond deposition device 10 may form a base layer 22 containing a metal without carbon by using a first raw material gas G1 that does not contain carbon. In this case, for example, nuclei may be formed on the base layer 22 by BEN treatment. In the above variation, similarly, an intercalation layer 24 that does not contain carbon may be formed, and nuclei may be formed on the intercalation layer 24 by BEN treatment.

In the above embodiment, the gas generator 11b is configured to evaporate liquid alcohol 11c housed in the housing 11a in which an organometallic compound is dissolved. However, without limitation, the gas generator 1 1b may also be configured to evaporate a solid organometallic compound by heating.

The subject of the present disclosure may be a program PG. In this case, the program PG may be stored in a computer-readable recording medium, such as universal serial bus (USB) memory, CD-ROM, digital versatile disc (DVD), or hard disk drive (HDD) or may be downloaded to a computer via a network.

The above embodiment discloses, for example, the technical ideas described in the following Supplementary Notes. Note that Supplementary Notes 1 to 5 are not to be construed as limiting the present disclosure in any way.

### (Supplementary Note 1)

A diamond deposition method for forming a single-crystal diamond layer by a CVD method using a second raw material gas containing a hydrocarbon gas, wherein the second raw material gas is mixed with a first raw material gas containing at least one metal selected from the group consisting of iridium, platinum, rhodium, titanium and tungsten to mix the metal into the diamond layer.

Conventionally, defects in diamond layers such as dislocations have been an issue. However, the above configuration is expected to suppress defects such as dislocations in diamond layers.

### (Supplementary Note 2)

A diamond material comprising a base layer containing at least one metal selected from the group consisting of iridium, platinum, rhodium, titanium and tungsten, and a single-crystal diamond layer formed on the base layer.

### (Supplementary Note 3)

The diamond material according to Supplementary Note 2, wherein the base layer contains carbon that serves as nuclei of the diamond layer.

### (Supplementary Note 4)

A diamond deposition method including: an intercalation layer formation step of forming an intercalation layer on a first diamond layer by a CVD method using a first raw material gas containing at least one metal selected from the group consisting of iridium, platinum, rhodium, titanium, and tungsten; and a diamond layer formation step of forming a second diamond layer, a diamond layer different from the first diamond layer, on the intercalation layer by the CVD method using a second raw material gas containing a hydrocarbon gas.

### (Supplementary Note 5)

Included are: a base layer formation step of forming a base layer by a CVD method using a first raw material gas containing at least one metal selected from a group consisting of iridium, platinum, rhodium, titanium, and tungsten; a diamond layer formation step of forming a single-crystal diamond layer on the base layer by the CVD method using a second raw material gas containing a hydrocarbon gas; an intercalation layer formation step of forming an intercalation layer on the diamond layer by the CVD method using the first raw material gas; and a second diamond layer formation step of forming a second diamond layer, different from a first diamond layer that is the aforementioned diamond layer, on the intercalation layer by the CVD method using the second raw material gas, wherein, in the second diamond layer formation step, the second raw material gas is mixed with the first raw material gas to mix the metal into the second diamond layer.

The foregoing describes some example embodiments for explanatory purposes. Although the foregoing discussion has presented specific embodiments, persons skilled in the art will recognize that changes may be made in form and detail without departing from the broader spirit and scope of the invention. Accordingly, the specification and drawings are to be regarded in an illustrative rather than a restrictive sense. This detailed description, therefore, is not to be taken in a limiting sense, and the scope of the invention is defined only by the included claims, along with the full range of equivalents to which such claims are entitled.

This application claims the benefit of Japanese Patent Application No. 2021-113975, filed on July 9, 2021, the entire disclosure of which is incorporated by reference herein.

### Reference Signs List

- 10: Diamond deposition device
- 11: First raw material gas supplier
- 11a: Housing
- 11b: Gas generator
- 11c: Alcohol
- 12: Second raw material gas supplier
- 13: Microwave supplier
- 14: Chamber
- 14i: Gas suction hole
- 14o: Gas discharge hole
- 15: Controller
- 15a: Processor
- 15b: Memory
- 16: Carrier gas supplier
- 17: Suction
- 18: Gas tube
- 19: Substrate supporter
- 20, 20a: Diamond material
- 21: Substrate
- 22: Base layer
- 23, 25: Diamond layer
- 24: Intercalation layer
- G1: First raw material gas
- G2: Second raw material gas
- Gc: Carrier gas
- PG: Program

## Claims

1. A diamond deposition method comprising:
a base layer formation step of forming a base layer by a CVD method using a first raw material gas containing at least one metal selected from a group consisting of iridium, platinum, rhodium, titanium, and tungsten; and
a diamond layer formation step of forming a single-crystal diamond layer on the base layer by the CVD method using a second raw material gas containing a hydrocarbon gas.

2. The diamond deposition method according to claim 1, wherein
in the base layer formation step, the base layer mixed with carbon is formed by the CVD method using the first raw material gas containing an organometallic compound in which the metal and the carbon are bonded, and
in the diamond layer formation step, the diamond layer is formed with the carbon mixed in the base layer as nuclei.

3. The diamond deposition method according to claim 1 or 2, further comprising:
an intercalation layer formation step of forming an intercalation layer on the diamond layer by the CVD method using the first raw material gas; and
a second diamond layer formation step of forming a second diamond layer, different from a first diamond layer that is the diamond layer, on the intercalation layer by the CVD method using the second raw material gas, the second diamond layer formation step being different from a first diamond layer formation step that is the diamond layer formation step.

4. The diamond deposition method according to claim 1 or 2, wherein in the diamond layer formation step, the second raw material gas is mixed with the first raw material gas to mix the metal into the diamond layer.

5. A diamond deposition device comprising:
a chamber;
a first raw material gas supplier to supply a first raw material gas containing at least one metal selected from a group consisting of iridium, platinum, rhodium, titanium, and tungsten into the chamber;
a second raw material gas supplier to supply a second raw material gas containing a hydrocarbon gas into the chamber; and
an energy supplier to provide energy to the first raw material gas that is supplied into the chamber by the first raw material gas supplier so as to form a base layer or an intercalation layer inside the chamber and to provide energy to the second raw material gas that is supplied into the chamber by the second raw material gas supplier so as to form a diamond layer on the base layer or the intercalation layer.

6. The diamond deposition device according to claim 5, wherein the first raw material gas supplier comprises:
a housing to house a solvent in which an organometallic compound in which the metal and carbon are bonded is dissolved; and
a gas generator to generate the first raw material gas by evaporating the solvent housed in the housing.

7. A program causing a computer to perform:
a base layer formation procedure of forming a base layer by a CVD method using a first raw material gas containing at least one metal selected from a group consisting of iridium, platinum, rhodium, titanium, and tungsten; and
a diamond layer formation procedure of forming a single-crystal diamond layer on the base layer by the CVD method using a second raw material gas containing a hydrocarbon gas.

8. A diamond material comprising:
a base layer containing at least one metal selected from a group consisting of iridium, platinum, rhodium, titanium, and tungsten;
a first diamond layer formed on the base layer;
an intercalation layer formed on the first diamond layer and configured to contain the same metal as the base layer; and
a second diamond layer formed on the intercalation layer, the second diamond layer being different from the first diamond layer.

9. The diamond material according to claim 8, wherein one or both of the first diamond layer and the second diamond layer are formed with a diffused component of the same metal as the base layer.
